# EUROPEAN PATENT APPLICATION

(11) **EP 0 566 963 A2**
(43) Date of publication of application: **27.10.1993**
(21) Application number: 93105982.8
(22) Date of filing: 13.04.1993
(51) Int. Cl.: G01B 7/34, H01J 37/22

(54) **A specimen image producing apparatus**

(30) Priority: 24.04.1992 JP 106405/92
(71) Applicant: HITACHI, LTD., Chiyoda-ku, Tokyo 101 (JP)
(72) Inventor: Sato, Mitsugu, Katsuta-shi, Ibaraki 312 (JP)
(74) Representative: Strehl Schübel-Hopf Groening & Partner

(57) **Abstract**

A specimen (4) is scanned with a focused electron beam under a plurality of focusing conditions to generate corresponding two-dimensional image signals. A three-dimensional information image is produced on the basis of each focusing condition and each corresponding two-dimensional image signal.

## Description

### Field of the Invention

The present invention relates to a specimen image producing apparatus, and more particularly to a specimen image producing apparatus for producing an image of a specimen by scanning the same with a charged-particle beam.

### Description of the Prior Art

As well known, in a scanning electron microscope, an electron beam is focused on a specimen by a focusing lens system, the specimen is scanned with the focused electron beam so as to generate an information signal characteristic of the specimen such as secondary electron signal and backscattered electron signal therefrom, and the generated information signal is used to produce an image of the specimen to be displayed on a display.

In such a scanning electron microscope, it is recognized as important to conduct the three-dimensional surface morphological observation of the specimen and thus many attempts have been made heretofore to this end. The most typical method for observing the surface outline of the specimen in three dimensions is to photograph two images of the specimen obtained when the incident angle of the electron beam on the specimen is selectively set to -ϑ and +ϑ. The incident angle of the electron beam on the specimen may be set by tilting the specimen relative to the electron beam. The setting of the incident angle may also be made by tilting the electron beam relative to the sample as disclosed in Japanese patent application laid-open No. 61-19044(1986). Further, it is possible to quantitatively measure three-dimensionally the surface structure of the specimen by analyzing the photographed images as disclosed in Japanese patent application laid-open No. 62-96807(1987).

In the case where a portion of interest on the surface of the specimen is composed of a protrusion and/or recess the distance between the top and bottom of which exceeds the depth of focusing of the focusing lens system, however, it is difficult to observe and measure the portion of interest on the surface of the specimen. This problem can be overcome by reducing the angular aperture of the electron beam, since thereby the depth of focus is increased. This, however, causes the electron beam to be widen due to the electron diffraction, resulting in a degraded resolution. In the case where the deepness of a hole on the surface of a specimen is greater than the depth of focus of the focusing lens system, the combining of a plurality of scanning electron microscopic images each obtained by varying the focusing position of an electron beam relative to the specimen described in "The principle of Cyclotron SEM and its Application" by Nomura et al.,NIKKEI MICRO DEVICES, December, 1991. This method, however, although it can improve resolution, neither contemplates nor suggests any idea to three-dimensionally observe and measure a portion of interest on the surface of a specimen.

In an ion microanalyzer, a sample or specimen is scanned with a focused ion beam to thereby generate secondary ions or secondary electrons from the specimen, and the generated secondary information may be used not only for conducting the analysis of the specimen in the direction of deepness thereof but also for producing an image of the specimen. The above mentioned problems in connection with the scanning electron microscope are also applicable to the ion microanalyzer.

### Summary of the Invention

An object of the present invention is to provide a specimen image producing apparatus adapted to three -dimensionally observe the surface of a specimen.

Another object of the present invention is to provide a specimen image producing apparatus adapted to three-dimensionally observe that portion of interest on the surface of a specimen which is composed of a protrusion and/or recess, even if the height or deepness of the portion is greater than the depth of focus of a focusing lens system for focusing a charged-particle beam on the specimen.

An additional object of the present invention is to provide a specimen image producing apparatus adapted to three-dimensionally observe the surface of a specimen without tilting one of the specimen and a charged-particle beam directed to the specimen relative to the other thereof.

A yet another object of the present invention is to provide a specimen image producing apparatus adapted to measure the height or deepness of that portion of interest on the surface of a specimen which is composed of a protrusion and/or recess.

A further object of the present invention is to provide a specimen image producing apparatus adapted to three-dimensionally observe and measure a portion of interest on the surface of a specimen.

According to the present invention, a specimen image producing apparatus is provided which comprises means for generating a charged-particle beam, means for focusing the charged-particle beam on a specimen, means for scanning the specimen with the focused charged-particle beam in two dimensions under a plurality of focusing conditions so as to generate corresponding two-dimensional image signals from the specimen, respectively, and means for producing a three -dimensional information image on the basis of the plurality of focusing conditions and the corresponding two-dimensional image signals.

The other objects, features and advantages of the present invention will be apparent from the following description of preferred embodiments of the present invention in connection with the accompanying drawings.

### Brief Description of the Drawings

Fig.1 is a diagrammatic view, partly in section and partly in block form, of a specimen image producing apparatus showing an embodiment according to the present invention;
Fig.2(a) is a view showing a relationship between a specimen and an electron beam with which the specimen is scanned;
Fig.2(b) is a view showing a waveform of the intensity of a signal detected during the scanning of the specimen with the electron beam;
Fig.2(c) is a view showing a differentiated waveform of the waveform shown in Fig.2(b);
Fig.3(a) is a view illustrating a three-dimensional information image of the specimen obtained by an embodiment of the present invention;
Fig.3(b) is a view illustrating another three -dimensional information image of the specimen obtained by an embodiment of the present invention;
Fig.4 is a view showing a flow chart for producing two-dimensional images of the specimen in accordance with an embodiment of the present invention;
Fig.5 is a view showing a flow chart for three -dimensionally measuring the specimen in accordance with an embodiment of the present invention;
Fig.6(a) is a view illustrating a relationship between the specimen disposed horizontally and the electron beam with which the specimen is scanned;
Fig.6(b) is a view illustrating a relationship between the inclined specimen and the electron beam with which the specimen is scanned;
Fig.7 is a longitudinal sectional view of another embodiment of an objective lens for use in a specimen image producing apparatus according to the present invention.

### Description of the Preferred Embodiment

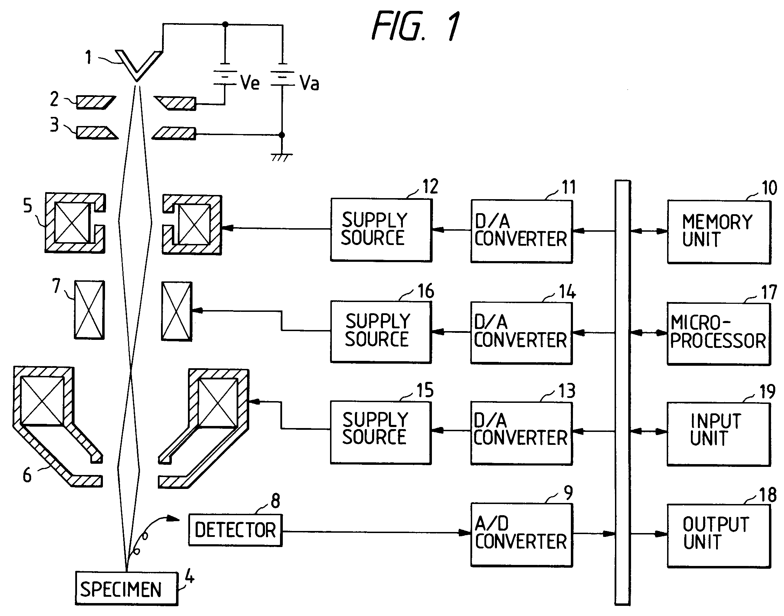

Referrig to Fig.1, there is shown an embodiment of a scanning electron microscope according to the present invention.

An extraction voltage Ve is applied between a field emission tip 1 and an extraction electrode 2, whereby electrons are field-emitted from the field emission tip 1, are passed through an opening of the extraction electrode 2 in the form of an electron beam and then are accelerated by an accelerating voltage Va applied between the field emission tip 1 and a grounded accelerating electrode 3 to thereby to be passed through an opening thereof.

The electron beam is focused on a specimen 4 by a focusing lens system which comprises a condenser lens 5 and an objective lens 6. Further, the focused electron beam is two-dimensionally deflected by a electron beam deflector 7 so that the specimen is two-dimensionally scanned with the focused electron beam, whereby secondary electrons, backscattered electrons, X-rays, and so on characteristic of the specimen 4 are generated therefrom. The secondary electrons are detected and converted into an electric signal by a detector 8. The electric signal is converted into a digital signal by an analog-to-digital converter 9 and then is stored in the form of a two-dimensional image signal, i. e. picture image signal in a frame memory included in a memory unit 10.

Stored in the memory unit 10 is each of an excitation current to be applied to the condenser lens 5, an excitation current to be applied to the objective lens 6 and a scanning signal to be applied to the electron beam deflector 7 in the form of a digital signal. In operation, therefore, the digital signal for the condenser lens 5 is read out from the memory unit 10 and is converted by the digital-to-analog converter 11 into an analog signal which drives a supply source 12 so as to energize the condenser lens 5. Similarly, the digital signals for the objective lens 6 and the electron beam deflector 7 are read out from the memory unit 10, respectively, and are converted by digital-to-analog converters 13 and 14 into analog signals which drive the supply sources 15 and 16 so as to energize the objective lens 6 and the electron beam deflector 7, respectively.

A microprocessor 17, in addition to the performing of various operations, is so operated as to not only vary the excitation current flowing through the objective lens 6 for changing the focusing position of the electron beam relative to the specimen 4 and the scanning signal applied to the electron beam deflector 7 for changing the observing magnification of the specimen but also display on an output unit 18 two markers and displace these separately from each other, in response to instructions from an input unit 19 which includes manipulators such as controls, buttons and keys.

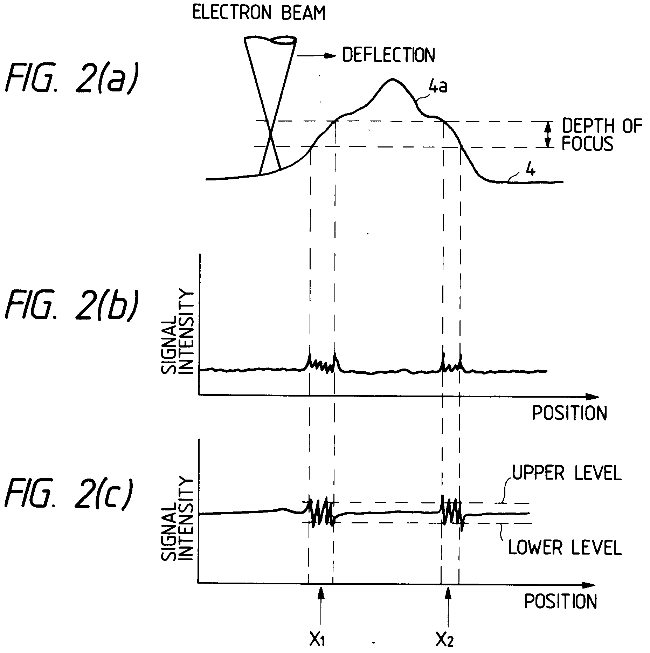

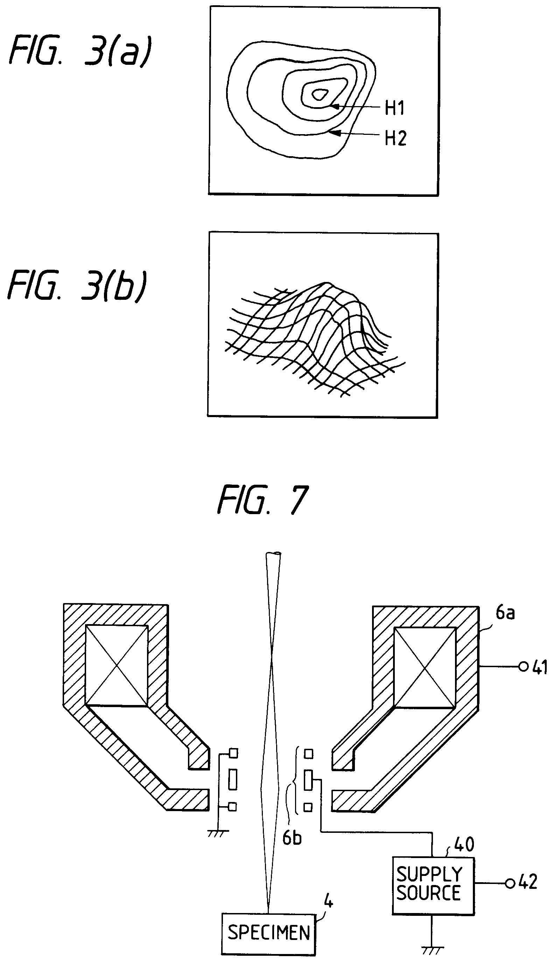

Referring to Fig.2, if a protrusion 4a on the surface of the specimen 4 is scanned with the electron beam as shown in Fig.2(a), the detector 8 outputs a signal to be stored in the frame memory which greatly changes within the depth of focus and does not substantially change out of the depth of focus because the electron beam is widen, as shown in Fig.2(b). If the outputted signal stored in the frame memory is subject to a differentiation processing, a waveform as shown in Fig.2(c) is obtained, and further, if upper and lower levels are set so that the differentiated signal within the depth of focus is out of the range smaller than the upper level and larger than the lower level, positions X1 and X2 are detectable distinguishably from other positions. Linking all of this position information over the entire two-dimensional image, i. e. picture image yields a two-dimensional position information image, i. e. cross -section contour image. Two-dimensional position information images, i. e. cross-section contour images are obtained in the same manner as above by changing the focusing position of the electron beam relative to the specimen, and further, a plurality of thus produced cross-section contour images are superposed on each other, whereby a three-dimensional information image of the specimen may be displayed in a contour map as shown in Fig.3(a). Further, by stacking cross-section contour images obtained at different focusing positions of the electron beam relative to the specimen, then by setting an appropriate view point, a three-dimensional information image may be displayed in a birds-eye view represented by a wire frame such as illustrated in Fig. 3(b).

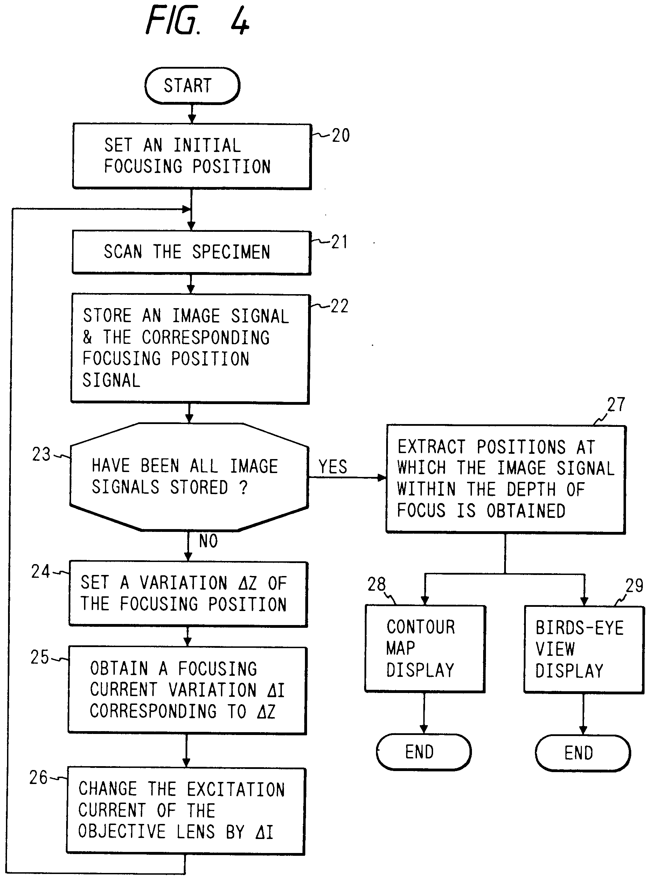

Operation will be made of an embodiment of the present invention with reference to a flow chart shown in Fig.4.

First, an initial or start focusing position of the electron beam relative to the specimen 4 is set as a standard or reference focusing position (Step 20). This reference focusing position may be set by the operator taking into account the height or deepness of protrusions and/or recesses on the surface of the specimen 4 in connection with the depth of focus of the objective lens 6. Then, the specimen 4 is two-dimensionally scanned with the electron beam under the focusing position condition set as above and under a given magnification condition (Step 21), an image signal generated thereby from the specimen being stored in the memory unit 10 as a two-dimensional image signal, i. e. picture image signal together with the focusing position condition under which the two-dimensional image signal has been obtained (Step 22). Subsequently, it is judged whether or not all the two-dimensional image signals, i. e. two-dimensional image signals have been stored together with corresponding focusing position conditions (Step 23).

In step 23, when the storage of all the image signals have not yet been completed, the following steps are continued. That is, a variation ΔZ in the focusing position necessary for producing a three-dimensional information image of the specimen is set (Step 24). Then, a variation ΔI in the excitation current of the objective lens 6 which causes the focusing position of the electron beam to change by ΔZ is set (Step 25). This may be calculated from ΔZ on the basis of a given relationship between the excitation current of the objective lens 6 and the focusing position of the electron beam relative to the specimen 4, or read out from a memory table prepared in advance which is representative of the relationship of ΔI values to ΔZ values corresponding thereto. Finally, after changing the excitation current of the objective lens 6 (Step 26), the flow chart step returns to the step 21 to repeat the steps 21 to 26.

In the step 23, when the storage of all the two -dimensional image signals is judged to have been completed, the step advances to the following three-dimensional information image generation and display processing.

First, with respect to each of the stored two -dimensional image signals, extraction is made of positions at which the two-dimensional image signal within the depth of focus is obtained, and the extracted positions are linked to each other to thereby form a two-dimensional position information image (Step 27). The followings may be used in order to discriminate positions where the image signal within the depth of focus is obtained from other positions.
(1) As explained in connection with Fig.2, a differentiation processing is applied to the two-dimensional image signal obtained by the scanning of the specimen with the electron beam.
(2) A two-dimensional Fourier transform is applied to the two-dimensional image signal obtained by the scanning of the specimen of the electron beam so as to extract by filtration higher spatial frequency components corresponding to the depth of focus. The extracted higher frequency components are image -reconstructed (that is, inverse Fourier transformed), result in a greater contrast. Therefore, the reconstructed image can be utilized as an extracted image made up only of positions in focus.

Such two-dimensional position information images as above further being represented by binary system in a line drawing and being stored in the memory unit 10 per corresponding focusing condition, i. e. focusing position of the electron beam relative to the specimen, they can be fetched to generate a set of three-dimensional coordinates expressing the outline of the surface of the specimen.

Further, on the basis of the three-dimensional coordinate data thus obtained, any desired three-dimensional information image corresponding to a specific object can be generated and displayed in the manners as follows.

### (1). Contour map (Step 28)

By conducting calculation for a coordinate transformation, shading or the like on a set of the three-dimensional position coordinates and from a view point for generating a birds-eye view, it is possible to generate and display a three-dimensional information image of the specimen in a birds-eye view. Also, with respect to this birds-eye view, each position at each point thereof in the travelling direction of the electron beam being definite, thereby it is possible to render each position in differentiated brightness or colors in response to each position in the travelling direction of the electron beam, thus capable of displaying a three-dimensional information image in a form easier to recognize on the display.

Heretofore, one example of generating and displaying of a three-dimensional information image according to the present invention has been described. As obviously to be understood from the foregoing principle of the present invention, a three -dimensional measurement can be implemented in the same manner as above.

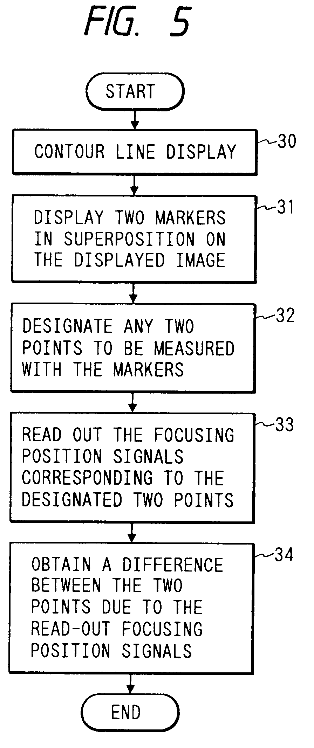

Fig.5 shows a flow chart of one embodiment for conducting a three-dimensional measurement according to the present invention. This embodiment illustrates an example of the three-dimensional measurement to be conducted utilizing the contour map display (Step 28) explained in Fig.4. Therefore, until the contour map displaying at 28, the same steps as in the flow chart of Fig.4 are carried out, thereat displaying the image of Fig.3(a). Step 28 is indicated as step 30 in Fig.5.

Two markers are displayed in superposition on the contour map as (Step 31) and points (H1,H2) desired to be measured are designated with the two markers shown in Fig.3(a) (Step 32). Next, in order to measure a distance between these two points (H1,H2) in the travelling direction of the electron beam, namely to conduct a three-dimensional measurement, position signals (Z1,Z2) corresponding to these two points (H1,H2) are read out from the memory unit 10 (Step 33). Because these position signals (Z1,Z2) indicate a height of each point (H1,H2), a difference ΔZ obtained between the position signals of these two points (Step 34) can be measured as a height between these designated two points (H1,H2). In the case that, by way of example, the focusing position of the electron beam is utilized as the position signals (Z1,Z2), a difference ΔZ between them directly indicates a height between the two points (H1,H2).

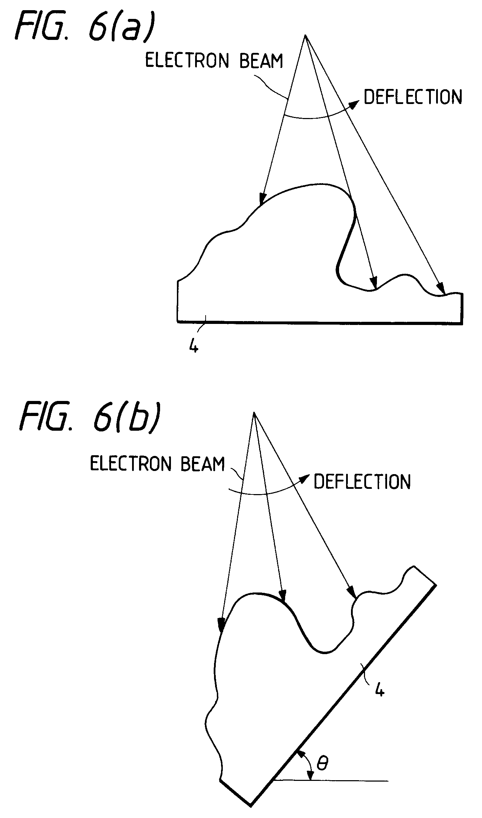

As shown in Fig.6(a), in the case that the protrusion of the specimen is obliquely oriented, there occurs a region that cannot be reached by the electron beam when subjected to the electron beam scanning. The same is also true in the case where the specimen has a hole or recess on the surface thereof whose bottom is wider than its entrance.

In the case of the scanning electron microscope, it is typical to employ for its objective lens a magnetic field lens featuring a small aberration, which, however, entails a problem that when controlling or setting a depth of focus within a desired range (a range for obtaining a three-dimensional structure), the set value sometimes includes an error due to the hysteresis of the magnetic poles. Fig.7 shows another example according to the present invention for preventing such an error from occurring, in which an objective lens comprises a magnetic field lens 6a and an electrostatic lens 6b disposed therein. According to this embodiment of the present invention, main focusing is performing by adjusting a current from a supply source (not shown) to the magnetic field lens 6a having a small aberration, and fine focusing is carried out by adjusting a voltage from a supply source 40 to the electrostatic lens 6b free from hysteresis. Thereby, it becomes possible to carry out a low aberration and high precision focusing adjustment. Incidentally, the control and adjustment of the magnetic field lens 6a and electrostatic lens 6b may be through terminals 41 and 42 by the microprocessor 17.

While the present invention has been particularly shown and described with reference to a preferred embodiment thereof, it will be understood by those skilled in the art that various changes in form and details may be made therein without departing from the spirit and scope of the present invention.

## Claims

1. A specimen image producing apparatus comprising
means (1...3) for generating a charged-particle beam,
means (5,6) for focusing the charged-particle beam on a specimen (4),
means (7) for scanning the specimen (4) with the focused charged-particle beam in two dimensions under a plurality of focusing conditions so as to generate corresponding two-dimensional image signals from the specimen (4), respectively, and
means (18) for producing a three-dimensional information image on the basis of the plurality of focusing conditions and the corresponding two-dimensional image signals.

2. The apparatus of claim 1, further comprising means (10) for storing the plurality of focusing conditions and the corresponding two-dimensional image signals, wherein the three-dimensional information image is produced on the basis of the stored plurality of focusing conditions and the stored corresponding two-dimensional image signals.

3. A specimen image producing apparatus comprising means (1...3) for generating a charged-particle beam,
means (5,6) for focusing the charged-particle beam on a specimen (4), means for scanning the specimen (4) with the focused charged-particle beam in two dimensions so as to generate a two-dimensional image signal from the specimen (4),
means (11, 12, 13, 15) for stepwise varying the focusing condition of the charged-particle beam focusing means (5,6) so as to generate a plurality of two-dimensional image signals from the specimen corresponding to the focusing conditions, respectively,
means (10) for storing the focusing conditions and the corresponding two-dimensional image signals, and
means (18) for producing a three-dimensional information image on the basis of the stored focusing conditions and the stored corresponding two-dimensional image signals.

4. The apparatus of any one of claims 1 to 3, wherein the charged-particle beam is an electron beam.

5. The apparatus of claim 4, wherein each focusing condition is defined by a focusing position of the electron beam relative to the specimen.

6. The apparatus of claim 5, wherein the electron beam focusing means includes an objective lens (6) and means (15) for supplying an excitation current thereto, and the focusing position of the electron beam relative to the specimen is determined by the excitation current of the objective lens (6).

7. The apparatus of any one of claims 1 to 6 further comprising means for extracting on the basis of the focusing conditions and the corresponding two-dimensional image signals second two-dimensional image signals so as to use the same for producing the three-dimensional information signal.

8. The apparatus of claim 7, wherein each second two-dimensional image signal comprises a differentiated signal of each of the two-dimensional image signals.

9. A specimen image producing apparatus according to claim 7, wherein each second two-dimensional image signal comprises a signal composed of signal components included in each of the two-dimensional signals and having a frequency substantially higher than a predetermined frequency.

10. The apparatus of any one of claims 4 to 9, wherein the specimen (4) and the electron beam are tilted relatively to each other.

11. The apparatus of any one of claims 1 to 10, further comprises means for displaying the three-dimensional information image.

12. The apparatus of claim 11, wherein the three-dimensional information image displaying means is so operated as to display each two-dimensional image signal in a contour line corresponding to a focusing condition.

13. The apparatus of claim 11, wherein the three-dimensional information image displaying means is so operated as to display each two-dimensional image signal corresponding to a focusing condition in different color and brightness.

14. The apparatus of claim 11, wherein the three-dimensional information image displaying means is so operated as to display the three-dimensional information image in a birds-eye view.

15. The apparatus of any one of claims 11 to 14, further comprising means for designating two points on the three-dimensional information image, and means for obtaining the distance between the designated two points in the travelling direction of the charged-particle beam on the basis of the focusing conditions.

16. The apparatus of any one of claims 4 to 15, wherein the electron beam focusing means comprising an objective lens (6) including a magnetic field lens (6a), and an electrostatic lens (6b) disposed inside the magnetic field lens (6a), the electrostatic lens (6b) being adapted to vary the focusing condition.
